# EUROPÄISCHE PATENTANMELDUNG

(11) **EP 1 022 120 A2**
(43) Veröffentlichungstag der Anmeldung: **26.07.2000**
(21) Anmeldenummer: 00890004.5
(22) Anmeldetag: 05.01.2000
(51) Int. Cl.: B30B 15/06, C23C 30/00, B32B 31/20

(54) **Plattenförmiges Presswerkzeug und Verfahren zu dessen Herstellung**

(30) Priorität: 21.01.1999 AT 8299
(71) Anmelder: Böhler Bleche GmbH, 8680 Mürzzuschlag (AT)
(72) Erfinder: Kügler, Alfred Dr., 8680 Mürzzuschlag (AT); Jerlich, Werner Josef, 8665 Langenwang (AT)
(74) Vertreter: Wildhack, Helmut, Dr. Dipl.-Ing.

(57) **Zusammenfassung**

Die Erfindung betrifft ein plattenförmiges Preßwerkzeug für die Herstellung von flächigen Schichtkörpern aus Kunstharz, die mindestens auf einer Flächenseite eine Auflage tragen. Insbesondere bezieht sich die Erfindung auf Preßbleche zur Fertigung von Leiterplatten sowie auf ein Verfahren zur Herstellung der Preßbleche. Erfindungsgemäß ist vorgesehen, daß die Arbeitsfläche des beheizbaren Preßwerkzeuges einen thermischen Längenausdehnungskoeffizient besitzt, dessen Wert mit jenem des Auflagewerkstoffes einen Unterschied von höchstens 2,5 x 10⁻⁶ /K aufweist, sowie eine Härte von größer als 44 HRC besitzt und gegebenenfalls eine Hartschicht trägt.

Das erfindungsgemäße Verfahren sieht vor, in einem ersten Schritt ein Rohblech mit hoher Güte und Planparallelität der gegenüberliegenden Flächen herzustellen, worauf zumindest eine Seite des Bleches mit einer Hartschicht mit einer Dicke von 5 µm bis 55 µm versehen wird.

## Beschreibung

Die Erfindung betrifft ein plattenförmiges Preßwerkzeug für die Herstellung von flächigen, mindestens auf einer Flächenseite eine Auflage tragenden Schichtkörpern aus Kunstharzen, gegebenenfalls mit Faserverstärkung, bei erhöhter Temperatur. Weiters umfaßt die Erfindung ein Verfahren zur Herstellung von plattenförmigen Preßwerkzeugen zur Bearbeitung von technischen Laminaten, insbesondere zur Fertigung von Kupferschichten aufweisenden Leiterplatten.

Technische Laminate sind flächige Körper, welche durch ein Übereinanderlegen und Warmpressen von Trägerschichten, die mit Kunstharz, zum Beispiel Phenolharz, getränkt sind, hergestellt werden. Als Trägerschicht sind Papier, Fasermatten, wie Glasfasermatten und dergleichen verwendbar. Der bei erhöhter Temperatur ablaufende Härtevorgang des Kunstharzes kann dabei in Teilschritten erfolgen, so daß teil- oder vorausgehärtete Platten bereitgestellt, mit Auflagen oder dergleichen versehen und/oder übereinandergelegt und zwischen plattenförmigen Preßwerkzeugen, zum Beispiel Preßblechen, unter Einwirkung von Preßkräften und Wärme vollkommen ausgehärtet werden können, wodurch auch sogenannte Mehrlagenplattenkörper herstellbar sind.

Leiterplatten, die für die Fertigung von elektronischen Geräten und dergleichen Bauteilen Verwendung finden, sind Kunstharz- Schichtkörper, die mindestens einseitig eine Metall, - insbesondere eine Kupfer- Auflage tragen. Hergestellt werden diese Leiterplatten derart, daß eine insbesondere 5 µm bis 35 µm dicke Kupferfolie auf die Seitenfläche(n) der vorgehärteten Schichtkörper aufgelegt, zwischen Preßblechen mit höchster Oberflächengüte eingespannt und unter Druck auf eine Temperatur zwischen 150°C und 450°C erwärmt werden, wobei eine volle Aushärtung des Kunstharzes erfolgt.

Preßbleche für technische Laminate weisen eine Flächengröße von bis zu 3,0 m² und mehr auf und haben im wesentlichen eine Dicke von 0,8 mm bis 3,0 mm bei einem möglichst geringen Dickenunterschied und höchster Oberflächengüte. Auf Grund der chemischen Beanspruchungen und des atmosphärischen Angriffes müssen diese Preßwerkzeuge eine hohe Korrosionsbeständigkeit und eine hohe Härte sowie hohe Verschleißfestigkeit besitzen. Zur Erfüllung dieser Erfordernisse werden für Preßbleche zumeist martensitische Chromstähle eingesetzt, wobei die Bleche nach besonderen Härteverfahren vergütet werden. Auch ausscheidungshärtbare Eisenbasislegierungen werden als Preßblechwerkstoffe eingesetzt.

Als großer Nachteil dieser Preßblechwerkstoffe ist deren vergleichsweise geringer thermischer Längenausdehnungskoeffizient von 10,0 x 10⁻⁶/K bis 13,0 x 10⁻⁶/K bei Raumtemperatur zu sehen. Wird beim Herstellvorgang der Leiterplatte die Arbeitsfläche des Preßbleches auf die Kupferfolie des Schichtkörpers angedrückt und das System auf die Aushärtetemperatur von beispielsweise 230°C gebracht, so dehnt sich das Kupfer mit einem thermischen Längenausdehnungskoeffizienten von 16,8 x 10⁻⁶/K stärker aus als die Preßfläche des Werkzeuges. Dieser Unterschied im Ausdehunungsverhalten von Werkzeug und Auflage des Schichtkörpers bei einer Erwärmung auf Aushärtetemperatur des Harzes kann zu Verwerfungen und Faltenbildungen der Kupferfolie führen und derartige Leiterplatten unbrauchbar machen.

Um diesen Nachteil zu vermeiden wurde schon versucht, die Preßbleche aus einem Werkstoff zu fertigen, welcher zumindest annähernd den Ausdehnungskoeffizient des Auflagemetalles Kupfer besitzt. Neben Hartbronzen wurden austenitische Stähle und dergleichen Legierungen eingesetzt, deren thermischer Längenausdehnungskoeffizient bei 16 x 10⁻⁶/K bis 17 x 10⁻⁶/K liegt. Mit diesen Werkzeug-Materialien können zwar Falten und Verwerfungen der Auflagefolie bei der Aushärtung des Harzes des Schichtkörpers bzw. durch eine Temperaturerhöhung beim Pressen vermieden werden, die Lebensdauer derartiger Preßbleche ist jedoch gering. Dieser Nachteil wird dadurch verursacht, daß auf Grund der geringen Härte sowie der Fließeigenschaften bei örtlicher Druckbeanspruchung dieser Werkstoffe und deren geringer Verschleißfestigkeit wegen, Eindrücke, zum Beispiel durch Fremdkörper wie Körner und dergleichen und/oder Ränder oder Kanten der Schichtkörper, in der Arbeitsfläche gebildet werden können. Diese Eindrücke bewirken bei der Pressung der nachfolgenden Leiterplatte eine Erhebung in der Metallauflage, was sich bei einem Ätzen der Leiterbahnen bedingt durch einen unterschiedlichen ohmschen Widerstand in diesem Schichtbereich nachteilig auswirkt.

Hier will die Erfindung Abhilfe schaffen und setzt sich zum Ziel, die Nachteile der bekannten Preßblechwerkstoffe zu beseitigen und ein Werkzeug der eingangs genannten Art zu erstellen, mit welchem bei verbesserter Güte der Schichtkörper, insbesondere von Leiterplatten, eine hohe Standzeit erreicht werden kann. Auch ist es Aufgabe der Erfindung ein Verfahren zu schaffen, mit welchem verbesserte Preßwerkzeuge zur Bearbeitung von technischen Laminaten, insbesondere von Leiterplatten erstellt werden können.

Dieses Ziel wird bei einem gattungsgemäßen Werkzeug erfindungsgemäß dadurch erreicht, daß die Arbeitsfläche des erwärmbaren Preßwerkzeuges, welche beim Preßvorgang an der Auflage insbesondere an einer Metallauflage des Schichtkörpers anliegt, einen thermischen Längenausdehungskoeffizient, dessen Wert im Vergleich mit jenem des Auflagewerkstoffes insbesondere eines Auflagemetalles einen Unterschied von höchstens 2,5 x 10⁻⁶/K vorzugsweise von geringer als 2,0 x 10⁻⁶/K insbesondere unter 1,4 x 10⁻⁶/K aufweist und eine Härte von größer 44 HRC besitzt.

Die durch die Erfindung erzielten Vorteile bestehen insbesondere darin, daß die bei einer Temperaturänderung gebildeten Scherspannungen bzw. die Spannungen in Richtung der wirksamen Preßfläche im System derartig gering gehalten werden können, daß keine nachteilig wirksamen Verwerfungen oder Falten der Auflage entstehen. Dabei ist es wichtig, daß die Materialhärte des Werkzeuges an der Arbeitsfläche einen Wert aufweist, der größer als 44 HRC ist, um Einprägungen durch Fremdkörper wie Staubkörner, Gratteile und dergleichen und/oder Ränder oder Kanten der Schichtkörper zu vermeiden.

Sowohl für eine Verbesserung des Korrosionswiderstandes als auch zur Verminderung von Verschleiß und einer Haftungsneigung der Arbeitsfläche des Werkzeuges ist es besonders günstig, wenn diese eine Hartschicht trägt. Von großem Vorteil sowohl für eine verbesserte Werkzeugstandzeit als auch für eine hohe Erzeugnisgüte hat es sich erwiesen, wenn ein Preßblech aus korrosionsbeständigem Metall oder einer dergleichen Legierung mit kubisch flächenzentrierter Atomstruktur für die Herstellung von technischen Laminaten mit Kupferauflagen bzw. Kupferschichten, zum Beispiel Leiterplatten, gebildet ist. Kupfer besitzt eine kubisch flächenzentrierte Atomstruktur, worin die Ursache für eine vorteilhaft ähnlich ausgebildete Wärmedehnung begründet sein könnte.

Wenn, wie gefunden wurde, das Preßwerkzeug bzw. das Preßblech aus korrosionsbeständigem austenitischen Stahl besteht und an der Arbeitsfläche eine mikrorissige Heißchrom/Hartchromschicht mit einer Härte von größer 900 HV_{0,1} trägt, können überragend hohe Werkzeugstandzeiten bei bester Erzeugnisgüte erreicht werden, auch wenn dünne Kupferfolien im Bereich von 5 um als Auflage am Schichtkörper Verwendung finden. Obwohl im Vergleich mit austenitischem Stahl Chrom um einen ca. 2,5fach geringeren thermischen Längenausdehnungskoeffizient von 6,6 x 10⁻⁶/K aufweist, kann mittels der Heißverchromung eine dünne, auf der Unterlage festhaftende, Hartchromschicht, welche der thermischen Längenänderung des Basisköpers folgt, auf diesen aufgebracht und endbehandelt werden. Die Verformbarkeit der Chromschicht trotz hoher Härte ist wahrscheinlich durch deren mikrorissige Ausbildungsform begründet.

Alternativ kann die Hartschicht an der Arbeitsfläche durch eine hochphosphorige Chemisch-Nickel-Schicht mit einer Härte von größer als 900 HV_{0,1} gebildet werden. Die autokatalytische Nickel - Phosphorabscheidung wird durch Tempern in eine Struktur mit hoher Härte übergeführt und besitzt einen vorteilhaft verbesserten Korrosionswiderstand. Um eine weitere Steigerung der Verschleißfestigkeit der Arbeitsfläche zu erreichen, kann in günstiger Weise vorgesehen sein, daß die Hartschicht als Dispersionsschicht ausgebildet ist. Dispersionsschichten haben Hartstoffpartikel, zum Beispiel aus Diamant oder Siliziumkarbid, in der Hartschicht dispers eingelagert.

Die weitere Aufgabe der Erfindung, ein Verfahren der eingangs genannten Art zur Herstellung von Preßwerkzeugen anzugeben, wird dadurch erreicht, daß in einem ersten Schritt eine kubisch flächenzentrierte Atomstruktur aufweisende korrosionsbeständige Rohplatte bzw. ein Rohblech mit hoher Güte und mit großer Planparallelität der gegenüberliegenden Flächen, wobei der größte Dickenunterschied der Platte geringer als 0,1 mm vorzugsweise kleiner als 0,06 mm ist, hergestellt wird, worauf in einem Folgeschritt auf zumindest einer Seite der Platte oder des Bleches die Aufbringung einer Hartschicht mit einer Dicke von 5 µm bis 55 µm erfolgt. Die erfindungsgemäßen Vorteile sind im wesentlichen darin zu sehen, daß einerseits Rohbleche mit höchster Oberflächengüte auf Lager gehalten werden können und andererseits kurzfristig auf den Rohteil eine jeweils gewünschte oder geforderte Hartschicht aufgebracht werden kann, was vorteilhaft wirtschaftliche kurze Zeitspannen der Bereitstellung von fertigen Preßwerkzeugen erbringt. Besonders gute Gebrauchseigenschaften des Werkzeuges im Dauerbetrieb können erreicht werden, wenn auf die Rohplatte oder das Rohblech eine dehnbare Heißchrom/Hartchrom-Schicht mit Mikrorissen, vorteilhaft mit einer Dicke von 5 µm bis 30 µm, aufgebracht und nachfolgend endbehandelt wird. 1.

Bei starker Korrosionsbeanspruchung des Werkzeuges ist von Vorteil, wenn auf die Rohplatte bzw. auf das Rohblech autokatalytisch eine hochphosphorige Chemisch-Nickelschicht, in günstiger Weise mit einer Dicke von 5 um bis 55 um, aufgebracht und getempert wird.

Die Erfindung wird nachfolgend beispielhaft anhand von Untersuchungsergebnissen erläutert. Preßbleche aus einem ausscheidungshärtbaren nichtrostenden Chromstahl DIN-Werkstoff Nr. X5CrNiCuNb 17 4 mit einer Dicke von 2,0 mm, einer Härte von 49 HRC und einer besonderen Oberflächengüte wurden gefertigt und bei einer Leiterplattenfertigung eingesetzt. Auf Rohplatten wurden dabei Kupferfolien mit einer Dicke von 5 um + 10 % beidseitig aufgelegt, von den Preßblechen an die Schichtplatte angedrückt und das System zur Aushärtung des Kunstharzes auf 195°C erwärmt. Nach dem Ausspannen der Leiterplatten wurden diese untersucht und festgestellt, daß die Kupferauflage zwar eine gute Haftung an der Schichtplatte aufwies, jedoch eine wellige Form mit Falten und Überlagerungen besaß. Messungen erbrachten, daß das Preßblech mit einer Zusammensetzung gemäß obiger Werkstoff Nr. eine Wärmeausdehnung von 10,9x10⁻⁶/K hatte.

Alternativ erfolgte eine Herstellung von Preßblechen mit einer Dicke von 2,0 mm aus austenitischen CrNi-Stahl, die einerseits mit einer Heißchrom/Hartchromschicht mit einer Stärke von 14 µm sowie andererseits mit einer hochphosphorigen Chemisch-Nickel-Schicht mit einer Stärke von 46µm versehen werden. Nach dem Endbehandeln bzw. Tempern der Schicht wurden diese Preßbleche bei der Leiterplattenfertigung eingesetzt. An den Leiterplatten konnten keinerlei Falten oder Wellenbildungen der 5 µm starken Kupferauflage festgestellt werden, auch eine Großzahlerprobung in der Serie erbrachte geringe Haftneigung und wesentlich verbesserte Gütewerte. Die Messungen der Wärmeausdehnung der Preßbleche erbrachte Werte von 16,6 x10⁻⁶/K

## Patentansprüche

1. Plattenförmiges Preßwerkzeug für die Herstellung von flächigen, mindestens auf einer Flächenseite eine Auflage tragender Schichtkörper aus Kunstharz, gegebenenfalls mit Faserverstärkung, bei erhöhter Temperatur, **dadurch gekennzeichnet**, daß die Arbeitsfläche des erwärmbaren Plattenwerkzeuges, welche beim Preßvorgang an der Auflage, insbesondere an einer Metallauflage des Schichtkörpers, anliegt, einen thermischen Längenausdehnungskoeffizient besitzt, dessen Wert im Vergleich mit jenem des Auflagewerkstoffes, insbesondere des Auflagemetalles, einen Unterschied von höchstens 2,5 x 10⁻⁶/K, vorzugsweise von geringer als 2,0x10⁻⁶/K, insbesondere von unter 1,4 x 10⁻⁶/K, aufweist und eine Härte von größer als 44 HRC besitzt.

2. Preßwerkzeug nach Anspruch 1, **dadurch gekennzeichnet**, daß dessen Arbeitsfläche eine Hartschicht trägt.

3. Preßwerkzeug nach Anspruch 1 oder 2, **dadurch gekennzeichnet**, daß dieses als Preßblech aus korrosionsbeständigem Metall oder einer dergleichen Legierung mit kubisch flächenzentrierter Atomstruktur für die Herstellung von technischen Laminaten mit Kupferauflagen bzw. Kupferschichten, zum Beispiel Leiterplatten, gebildet ist.

4. Preßwerkzeug nach einem der Ansprüche 1 bis 3, **dadurch gekennzeichnet**, daß dieses bzw. das Preßblech aus korrosionsbeständigem austenitischen Stahl besteht und an der Arbeitsfläche eine mikrorissige Heißchrom/Hartchrom-Schicht mit einer Härte von größer als 900 HV_{0,1} trägt.

5. Preßwerkzeug nach einem der Ansprüche 1 bis 4, **dadurch gekennzeichnet**, daß die Hartschichten der Arbeitsfläche durch eine hochphosphorige Chemisch-Nickel- Schicht mit einer Härte von größer als 900 HV_{0,1} gebildet ist.

6. Preßwerkzeug nach einem der Ansprüche 1 bis 5, **dadurch gekennzeichnet**, daß die Hartschicht als Dispersionsschicht ausgebildet ist.

7. Verfahren zur Herstellung von plattenförmigen Preßwerkzeugen zur Bearbeitung von technischen Laminaten, insbesondere zur Fertigung von Kupferschicht(en) aufweisenden Leiterplatten, **dadurch gekennzeichnet**, daß in einem ersten Schritt eine eine kubisch flächenzentrierte Atomstruktur aufweisende korrosionsbeständige Rohplatte bzw. ein Rohblech mit hoher Güte und mit hoher Planparallelität der gegenüberliegenden Flächen, wobei der größte Dickenunterschied der Platte geringer als 0,1 mm, vorzugsweise 0,06 mm, ist, hergestellt wird, worauf in einem Folgeschritt auf zumindest einer Seite der Platte oder des Bleches die Aufbringung einer Hartschicht mit einer Dicke von 5 µm bis 55 µm erfolgt.

8. Verfahren nach Anspruch 7, **dadurch gekennzeichnet**, daß auf die Rohplatte bzw. auf das Rohblech eine dehnbare Heißchrom/Hartchrom-Schicht mit Mikrorissen aufgebracht und nachfolgend endbehandelt wird.

9. Verfahren nach Anspruch 7 oder 8, **dadurch gekennzeichnet**, daß eine Heißchrom/Hartchrom-Schicht mit einer Dicke von 5 µm bis 20 µm aufgebracht wird.

10. Verfahren nach Anspruch 7, **dadurch gekennzeichnet**, daß auf die Rohplatte bzw. auf das Rohblech autokatalytisch eine hochphosphorige Chemisch-Nickel - Schicht aufgebracht und getempert wird.

11. Verfahren nach Anspruch 7 oder 10, **dadurch gekennzeichnet**, daß eine Chemisch - Nickel- Schicht mit einer Dicke von 5 µm bis 55 µm aufgebracht wird.
